# EUROPEAN PATENT APPLICATION

(11) **EP 3 796 319 A1**
(43) Date of publication of application: **24.03.2021**
(21) Application number: 19198430.1
(22) Date of filing: 19.09.2019
(51) Int. Cl.: G11C 11/16, G11C 11/14, G11C 13/06

(54) **MEMORY DEVICE**

(71) Applicant: Institute of Physics, 162 00 Praha 6 (CZ)
(72) Inventor: Kaspar, Zdenek, Praha 6 (CZ); Novák, Vít, Praha 6 (CZ); Marti, Xavier, Praha 6 (CZ); Wunderlich, Joerg, Praha 6 (CZ); Jungwirth, Tomás, Praha 6 (CZ); Olejník, Kamil, Praha 6 (CZ)
(74) Representative: Piotrowicz, Pawel Jan Andrzej

(57) **Abstract**

A memory device is disclosed. The memory device comprises a memory element (2) comprising antiferromagnet (3) having first and second contacts (4, 5), and a circuit (8) for driving a current through the antiferromagnet between the first and second contacts. The circuit is configured, in a set mode (13), to drive a first current pulse having a first current density *j*_{w1} through the antiferromagnet in a first direction, wherein *jₜ* <*j*_{*w*1} where *jₜ* is a threshold current density for causing a change in resistance in the antiferromagnet, so as to set the memory element in a first state having a first resistance *R₁*, in a reset mode (14), to drive a second current having a second current density *j*_{*w*2} through the antiferromagnet in the first direction, wherein *jₜ <j_{w2} < j_{w}*1 so as to reset the memory element from the first state to a second state having a second resistance *R₂*, where (*R*₁ - *R*₂*)*/*R*₂ > 0.05, and, in a read mode (15), to drive a third current having a third current density *jᵣ* through the antiferromagnet, wherein *jᵣ* < *jₜ.*

## Description

### Field

The present invention relates to a memory device.

### Background

Recent demonstrations of electrical control of the magnetic order vector in antiferromagnets have initiated a new research front in spintronics mirroring the principles of operation of ferromagnetic memories. Antiferromagnetic memory devices with electrical writing and readout were realized using thin-film antiferromagnets or interfaces of an antiferromagnet and a paramagnet. The design of these devices was inspired by a picture of a current-induced staggered field generated by an electrical current in antiferromagnets with local inversion-symmetry breaking in the bulk crystal, or a model of electrical switching due to a spin-torque acting at the antiferromagnet/ paramagnet interface. Both scenarios are analogous to relativistic spintronics means of controlling the magnetic order vector in single-layer or multilayer ferromagnetic structures. In our earlier studies of antiferromagnetic memories, we have focused on the former scenario and identified a collinear room-temperature antiferromagnet CuMnAs as a material with the suitable crystal symmetry. Reference is made to P. Wadley et al., Scientific Reports 5,17079 (2015). Epilayers of CuMnAs can be deposited on silicon or III-V substrates and we fabricated demonstrator micro-devices embedded in common USB-powered printed circuit boards. Reference is made to P. Wadley et al., Science 351, 587 (2016) and M. J. Grzybowski et al., Physical Review Letters 118, 057701 (2017).

Encoding the stored information in these devices via the electrical control of the Neel vector was visualized by x-ray magnetic linear dichroism microscopy (XMLD-PEEM). Reference is also made to P. Wadley et al., Nature Nanotechnology 13, 362 (2018). The images of the onset of current-induced Neel vector reorientations, which could be recorded at writing currents densities as low as 5 × 10⁵ Acm⁻², were directly linked to the onset of corresponding electrical readout signals due to anisotropic magnetoresistance. 90° Neel vector switching was observed for orthogonal writing currents or, via domain wall motion, when reversing the polarity of the writing current. Bipolar 180° switching was also detected using a second-order magnetoresistance effect and reference is made to J. Godinho et al., Nature Communications 9, 4686 (2018). The basic concept of the operation of these antiferromagnetic devices shares the general principle of conventional magnetic memories in which the reversible control of the magnetic order vector requires changing the orientation of the writing current. Moreover, they also share the common limitation of single-layer films in which the reorientation of the magnetic order vector yields weak electrical readout signals; in previous studies of CuMnAs devices, the recorded resistive changes were only in a ∼ 0.1% range. The need of bi- or multi-polar writing has not been circumvented in magnetic memories to date. The limitation to low electrical signals has been lifted in ferromagnets by giant, ∼ 100% resistive changes achieved, however, at the expense of introducing man-made complex multilayer structures.

### Summary

According to a first aspect of the present invention there is provided a memory device. The memory device comprises a memory element comprising antiferromagnet having first and second contacts, and a circuit for driving a current between the first and second contacts through the antiferromagnet.

The circuit may be configured, in a set mode, to drive a first current pulse having a first current density *j*_{*w*1} through the antiferromagnet in a first direction, wherein *jₜ < j*_{*w*1} where *jₜ* is a threshold current density for causing a change in resistance in the antiferromagnet, so as to set the memory element in a first state having a first resistance *R*₁, in a reset mode, to drive a second current having a second current density *j*_{*w*2} through the antiferromagnet in the first direction, wherein *jₜ <j*_{*w*2} *< j*_{*w*1} so as to reset the memory element from the first state to a second state having a second resistance *R*₂, where (*R*₁ - *R*₂*)*/*R*₂ > 0.05, and, in a read mode, to drive a third current having a third current density jr through the antiferromagnet, wherein *j*ᵣ *< jₜ.*

The first current density *j*_{*w*1} may lie between 1.1×10⁷ Acm⁻² and 1.2×10⁷ Acm⁻².

The memory device may further comprise a laser system for directing laser pulse(s) at the antiferromagnet.

The laser system may be configured, in a set mode, to direct a first laser pulse having a first energy density Ew1 and a first pulse duration at the antiferromagnet, wherein *Eₜ < E*_{*w*1} where *Eₜ* is a threshold energy density for causing a change in a measurable property of the antiferromagnet, so as to set the memory element in a first state having a first value of the measurable property *R*₁. The laser system may be configured, in a reset mode, to direct a second laser pulse having a second energy density *E*_{*w*2} and a second pulse duration at the antiferromagnet, wherein *Eₜ* < *E*_{*w*2} < *E_{w}*1 so as to reset the memory element from the first state to a second state having a second value of the measurable property R₂, where (*R*₁ - R₂)/ R₂ > 0.05. The memory device may further comprise a reading system for measuring a value of the measurable property, the system configured in a read mode, to measure a value of the measurable property without causing a change in the measurable property the antiferromagnet.

The measurable property may be resistance, the antiferromagnet may have first and second contacts and the reading system may include a circuit for driving a current between the first and second contacts through the antiferromagnet.

The measurable property may be reflectivity and the reading system may include a laser orientatable at the antiferromagnet and a photodetector arranged to receive reflected light from the antiferromagnet.

The threshold energy density may be greater than or equal to 0.1 kJcm⁻³ or greater than or equal to 1 kJcm⁻³.

The ratio (*R*₁ - *R*₂*)*/ *R*₂ is preferably greater than 0.2 and more preferably greater than 0.9.

The first pulse duration may be less than or equal to 100 µs and may be between 100 fs and 100 µs. The first pulse duration may be greater than 100 µs.

The antiferromagnet may comprise a body (such as pad, strip, layer, dot or pillar) of antiferromagnetic material. The body of antiferromagnetic material may have a volume less than 0.1 µm³.

The memory element preferably does not include a ferromagnet.

The memory device may comprise an array of memory elements, each memory element comprising a respective antiferromagnet and a controller for controlling setting, resetting and reading of the memory elements in the array of memory elements.

According to a second aspect of the present invention there is provided a method of operating a memory device which comprises a memory element comprising an antiferromagnet. The method comprises, in a set mode, providing a first pulse of a first energy density *E*_{*w*1} and a first pulse duration at the antiferromagnet, wherein *Eₜ* < *E*_{*w*1} where *Eₜ* is a threshold energy density for causing a change in a measurable property of the antiferromagnet, so as to set the memory element in a first state having a first value of the measurable property *R*₁, in a reset mode, providing a first pulse of a second energy density *E*_{*w*2} and a second pulse duration at the antiferromagnet, wherein *Eₜ < E*_{*w*2} < *E*_{*w*1} so as to reset the memory element from the first state to a second state having a second value of the measurable property *R*₂, where (*R*₁ - *R*₂*)*/ *R*₂ > 0.05, and, in a read mode, measuring a value of the measurable property without causing a change in the measurable property the antiferromagnet.

The pulse(s) may include electromagnetic pulse(s), such as electrical pulse(s) and/or optical pulse(s).

The measurable property may be resistance.

The threshold energy density may be greater than or equal to 0.1 kJm⁻³ or greater than or equal to 1 kJm⁻³.

The first and second pulses may be provided by providing first and second current pulses respectively having first and second current densities respectively. The first current density may lie between 1.1×10⁷ Acm⁻² and 1.2×10⁷ Acm⁻².

The ratio (*R*₁ - R₂)/ R₂ is preferably greater than 0.2 and more preferably greater than 0.9.

The first pulse duration may be less than or equal to 100 µs and may be between 100 fs and 100 µs. The first pulse duration may be greater than 100 µs.

### Brief Description of the Drawings

Certain embodiments of the present invention will now be described, by way of example, with reference to the accompanying drawings, in which:
Figure 1A is a simulated writing current density map in a four-arm device for an average density *j_{w}* = 1.3 × 10⁷ Acm⁻²; the equivalent Wheatstone bridge circuit for transverse electrical readout is indicated in the map and electrical writing pulse direction is indicated by red arrows.

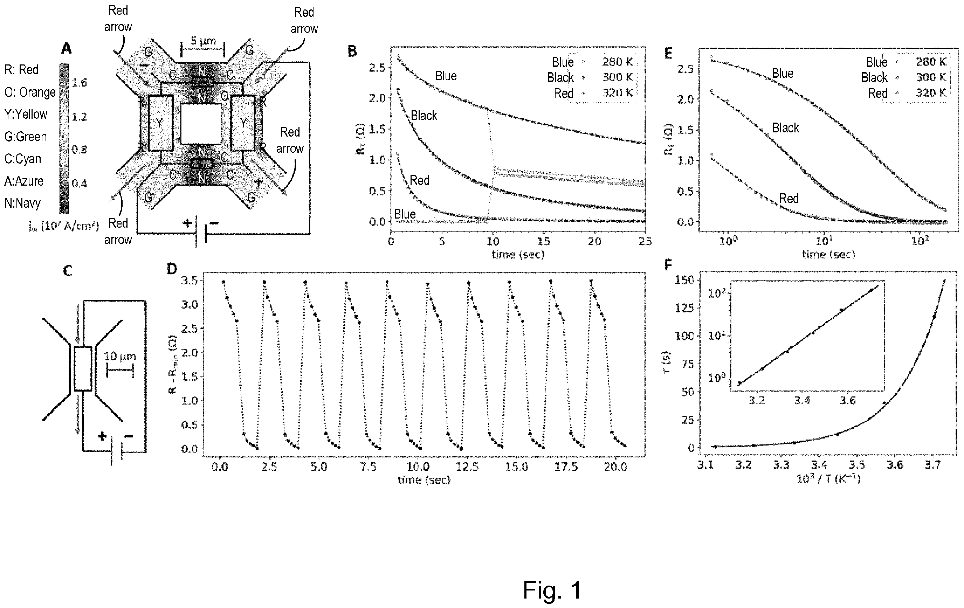

Figure 1B shows switching signals set at time o by a 100 µs long pulse of amplitude *j_{w}* = 1.36 × 10⁷ Acm⁻² at base temperature of 280 K (blue), *j_{w}* = 1.28 × 10⁷ Acm⁻² at 300 K (black), and *j_{w}* = 1.21 × 10⁷ Acm⁻² at 320 K (red); the readout signal is recorded from 660 ms after the pulse; dashed lines are stretched-exponential fits; at base temperature 280 K we show additional measurement, over-lapping with the above blue data till time 10 s, of the readout signal after a 100 µs setting pulse of *j_{w}* = 1.36 × 10⁷ Acm⁻² delivered at time 0. At time 10 s we delivered the same polarity 100 µs resetting pulse of *j_{w}* = 1.27 × 10⁷ Acm⁻² (blue); next we plot a signal for a 100 µs setting pulse of *j_{w}* = 1.27 × 10⁷ Acm⁻² delivered at time 10 s (blue with zero value till 10 s).
Figures 1C and 1D show unipolar set/reset measurements in a two-terminal resistor with *j_{w}* = 1.03/0.96 × 10⁷ Acm⁻².
Figure 1E is the same as corresponding data in Figure 1B with stretched-exponential fits, plotted in logarithmic scale.
Figure 1F shows temperature dependence of the relaxation time (points) with exponential fit (curve) in linear (main plot) and logarithmic (inset) scale; see hereinafter for parameters of the fits.
Figure 2A shows simulated writing current density maps for vertical (red arrows) and horizontal (black arrows) writing pulse direction and schematics of the transverse readout geometry.
Figure 2B shows transverse readout signal at 300 K measured for 20 s after a horizontal writing pulse (black) of 100 µs length and *j_{w}* = 1.28 × 10⁷ Acm⁻², followed by readout for 20 s after a vertical pulse (red).
Figure 2C shows, in an inset, a longitudinal readout geometry and, in a main panel, 30 min measurements at indicated base temperatures of the longitudinal readout signal after horizontal (black) and vertical (red) writing pulse of 100 µs length and *j_{w}* = 1.49 × 10⁷ Acm⁻² delivered at 250 K.
Figure 2D is the same as Figure 1B for the longitudinal readout at 300 K.
Figure 2E is a plot of relative switching signal as a function of the current amplitude of the writing pulse.
Figures 3A to C is the same as Figure 2B but with three successive writing pulses along horizontal direction followed by three successive pulses along vertical direction; the delay between pulses decreases from Figure 3A to Figure 3C.
Figure 4A is a plot of transverse readout signal recorded 550 ms after completing a scan of the switching laser beam over horizontal arm (black) followed by the same procedure over the vertical arm (red); the beam was focused to a 1 µm spot and delivered energy of 0.8 nJ per 100 fs pulse; laser pulse repetition rate was set to 80 kHz and the exposure of the arm was completed in 600 ms.
Figure 4B shows, in an inset, spatially resolved, pixel-by-pixel measurement of the readout signal; each micron-size pixel was exposed to a train of pulses with a 10 kHz repetition rate over 250 ms and, in a main plot, readout signal as a function of the number of pulses. Experimental procedure is as in Figure 4A with the repetition rate varied from 10 kHz to 1 MHz and energy of 0.7 nJ per 100 fs pulse.
Figure 4C shows optical writing at time o by a laser beam of 10 kHz repetition rate over 250 ms and with 0.8 nJ per 100 fs pulse, focused to a single 1 µm-diameter spot in the horizontal arm; at time 5 s (black) or 20 s (grey), a resetting laser pulse was applied defocused to a 1.8 µm-diameter spot; the same procedure was then applied to the vertical arm (red and yellow).
Figure 4D shows switching by a single 100 fs, 1 µm-focus pulse of 1 nJ delivered to one spot on the horizontal (black) and one spot on the vertical (red) arm in a device with 2.5 µm wide arms.
Figures 5A and 5B show writing current density map and corresponding temperature map at the end of the 100µs pulse in the four-arm Wheatstone bridge device; we show relative temperature maps because of the lack of reliable quantitative values of all relevant thermal conductivity coefficients; we estimate that the absolute transient temperature increase during the pulse is about ≈ 100 K.
Figure 5C shows time dependence of the temperature rise during the writing pulse and of the decay after the pulse.
Figure 6 shows measurements of the readout signal after a 100 µs setting pulse of *j_{w}* = 1.36 × 10⁷ Acm⁻² (black dashed line); measurements till time 10 s of the readout signal after a 100 µs setting pulse of *j_{w}* = 1.36 × 10⁷ Acm⁻² delivered at time o; at time 10 s we delivered the same polarity 100 µs resetting pulse of *j_{w}* = 1.19 × 10⁷ Acm⁻² (red), *j_{w}* = 1.26 × 10⁷ Acm⁻² (blue), *j_{w}* = 1.36 × 10⁷ Acm⁻² (green); all measurements are at base temperature 280 K.
Figures 7A to 7C show comparison of stretched-exponential fits with indicated values of the exponent *β* for measurements of the time dependent readout signal at 280 K;
experimental data are fitted with a formula *R_{T}* = *A* exp[-(t/*τ*)*β*] - *R*_{offset}; best agreement is achieved with *β* = 0.6; Figure 7B corresponds to the blue curve in Figure 1E.
Figures 8A and 8B show comparison of the transverse (Figure 8A) and longitudinal (Figure 8b) switching signal in the four-arm Wheatstone bridge device measured at o and 14 T; writing was done by 100µs, *j_{w}* =1.22 × 10⁷ Acm⁻² pulses at 300 K.
Figures 9A and 9B are same as Figures 5A and 5B in a cross device without the lithographically removed central square region.
Figure 9C shows switching readout signal in the cross device written by orthogonal 100µs, *j_{w}* = 1.43 × 10⁷ Acm⁻² pulses.
Figure 10A shows switching signal written by a 1 ns, *j_{w}* = 1.3 × 10⁸ Acm⁻² setting pulse (black) in the four-arm Wheatstone bridge device; signal written by a 1 ns, *j_{w}* = 1.3 × 10⁸ Acm⁻² setting pulse followed by a 1 ns, *j_{w}* = 1.1 × 10⁸ Acm⁻² resetting pulse (red).
Figure 10B shows switching signal after a single 1 ns, *j_{w}* = 1.2 × 10⁸ Acm⁻² pulse (black), and five (red) and ten (blue) 1 ns pulses.
Figure 11 is a schematic block diagram of an electrically set/reset memory device.
Figures 12A and 12B are plots of resistance against time for the device shown in Figure 9A illustrating deterministic switching between higher and lower resistance states, independent of the order of SET/RESET pulses and delay (relaxation) between pulses.
Figure 13 is a schematic block diagram of an optically set/reset memory device.
Figure 14A is a plot of resistance against time for a device shown in Figure 1C and
Figure 14B is a plot of reflectance change against time for the device shown in Figure 1C allowing comparison of electrical resistivity and optical reflectivity readouts of SET (higher) and RESET (lower) states.

### Detailed Description of Certain Embodiments

In established memory concepts, information is encoded in the atomic structure, electronic charge, or magnetic moment orientation. Here we introduce a distinct principle of information encoding allowed by antiferromagnets, which provides an unparalleled set of characteristics and functionalities. We demonstrate resistive readout signals in a single-layer magnetic film approaching 100%, unipolar reversible electrical switching, integrated memory with analog and logic functions in an elementary resistor, optical writing by a 100 fs pulse, insensitivity to magnetic field, and precise reproducibility of the switching patterns. The observed universal stretched-exponential relaxation supports our picture of information encoding in complex magnetic nano-textures whose macroscopic time stability stems from the absence of long-range dipolar coupling in antiferromagnets.

A combination of two earlier observations directs us towards the distinct memory concept introduced in this work. First, XMLD-PEEM images of CuMnAs devices have revealed an intrinsic ability of antiferromagnets to form metastable complex magnetic nano-textures within the film. This is attributed to the absence of long-range fields in antiferromagnets which makes them distinct from ferromagnetic or charge-based memories governed by long-range dipolar or Coulomb interactions. Second, *ab initio* transport calculations in CuMnAs have shown that the material's resistivity can increase by ∼ 100% upon introducing frozen nano-scale magnetic disorder.

The physical picture of our memory concept is based on information being encoded in the magnetic nano-textures instead of the magnetic order vector. Consistent with this picture we demonstrate a unipolar electrical set/reset functionality and large resistive readout signals in single-layer CuMnAs devices. The latter observation indicates that the complex nano-textures within the antiferromagnetic film can substitute the man-made complex multilayer structures used in ferromagnetic devices with large resistive switching ratios. Simultaneously, we show that our concept offers writing speeds combined with long retention times which is elusive in charge memories.

The unique set of characteristics described herein goes beyond the common digital operation of memories. We demonstrate multilevel switching combined with a universal Kohlrausch stretched-exponential relaxation. Besides confirming that we encode information in complex states, the functionality can be applied to mimic analogue neuromorphic components. Finally, we demonstrate optical control of the high-resistive metastable states by fs-laser pulses. The experiments confirm that our concept does not rely on the current induced reorientation of the magnetic order vector and the associated special symmetry of the antiferromagnetic crystal. The rich phenomenology that we illustrate in the optical section of our paper also brings our concept into the field of ultra-fast low-energy optical manipulation of magnets.

### Switching by electrical pulses

The experimental device geometry is shown in Figure 1A. The structure was lithographically patterned from a 50 nm CuMnAs epilayer grown by molecular beam epitaxy on an insulating GaP substrate. The device comprises two horizontal and two vertical arms forming effectively a Wheatstone bridge. In a uniform resistivity state, the bridge is balanced, resulting in zero voltage detected between the top-left and bottom-right contacts when sending the readout current between the other two contacts. The Wheatstone bridge geometry thus allows us to measure directly the resistive switching signal in a selected arm (arms) without the mean resistance offset. The four-point set up also removes any contribution of the contact resistance to the readout signal. In Figure 1A, sample colours are labelled R for red, O for orange, Y for yellow, G for green, C for cyan, A for azure and N for navy.

In experiments shown in Figure 1B, we applied a 100 µs writing current pulse in the vertical direction (red arrows in Figure 1A). Numerical simulations in Figure 1A show that the two vertical arms are exposed to a higher writing current density than the horizontal arms. The sign of the resulting readout signal *R_{T}* measured across the bridge corresponds to an increase of the resistance of the vertical arms, relative to the horizontal arms.

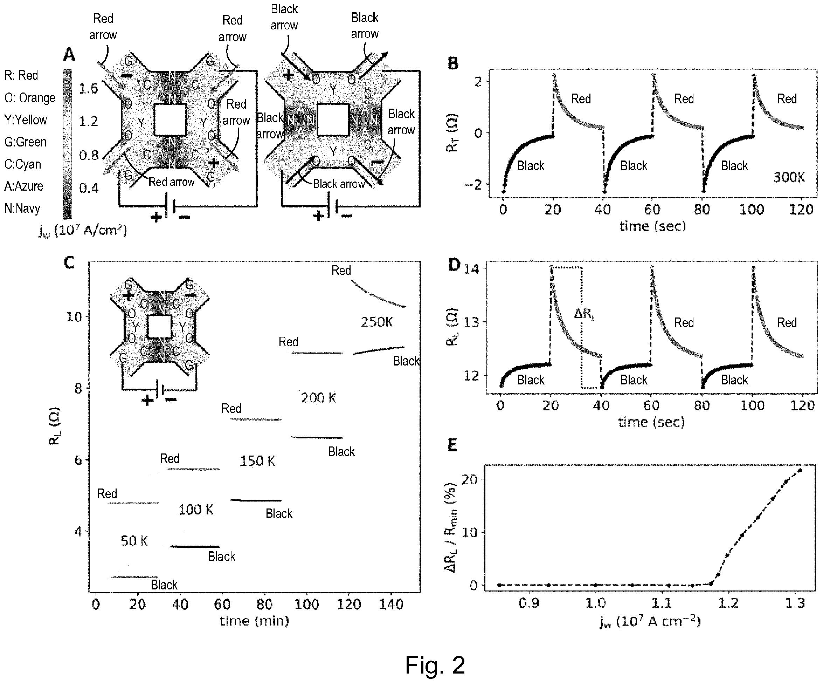

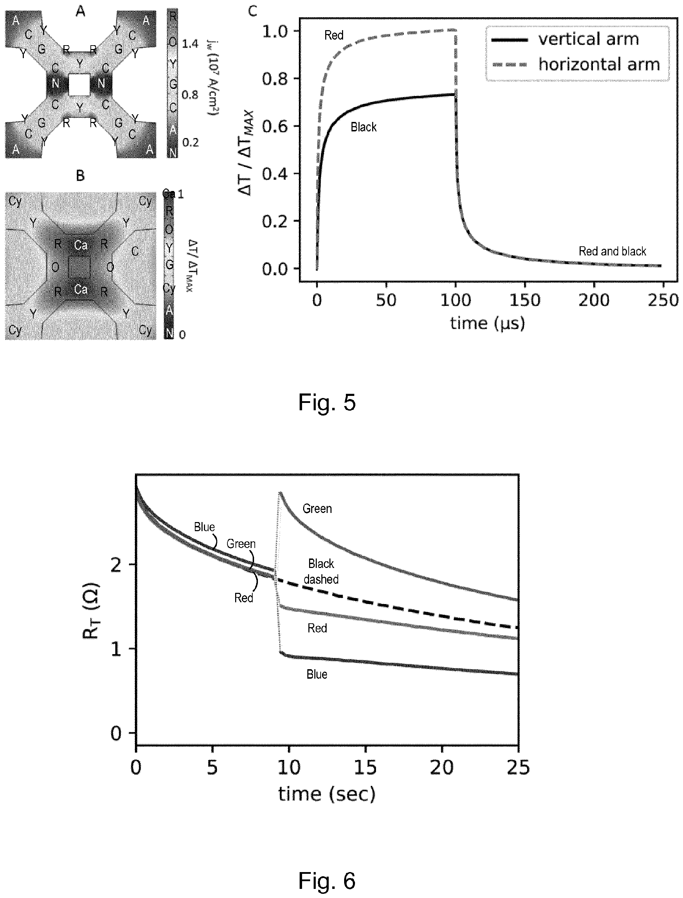

Remarkably, the high-resistive switching signal generated by the 100 µs writing pulse persists on macroscopic timescales while the device cools down to the base temperature after the pulse in microseconds (see Figure 5 herein after). Next, we repeated the setting experiment with a writing pulse of the same amplitude and length. After 12 s we applied another 100 µs pulse of the same polarity with an amplitude reduced by 7%. The second pulse has erased the state set by the first pulse to about a half of its value which illustrates the unipolar set/reset functionality in our memory. The reset function can be explained by the temperature dependence of the relaxation illustrated in Figure 1B on measurements at base temperatures from 280 to 320 K. Since the relaxation is accelerated at elevated temperatures, we can ascribe the drop of the signal to the transient heating of the device delivered by the weaker reset pulse. The memory state is not reset to a fully relaxed state because the resetting pulse amplitude we applied was also high enough to, on its own, generate a non-zero switching signal from the relaxed state, as shown in Figure 1B. The full dependence of the switching signal on the writing current amplitude is further discussed in relation to Figure 2E hereinafter. For more set/reset measurements with different amplitudes of the reset pulse see Figure 6 hereinafter.

The reproducible and reversible unipolar switching combined with electrical readout can be implemented in the simplest circuit element geometry of a two-terminal resistor, as shown in Figures 1C and 1D. This combined with the observed large resistive switching signal in the resistor made of a single magnetic layer makes our antiferromagnetic memory concept unparalleled in the family of magnetic memories.

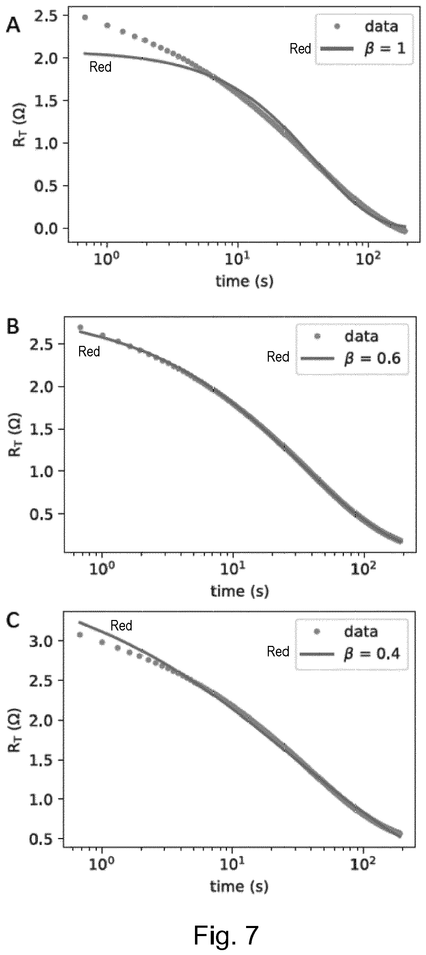

Before turning to a detailed discussion of the amplitude of the switching signal, we inspect in Figures 1E and 1F the relaxation characteristics of the signal. The functional form is universal to all studied temperatures and is fitted to a stretched exponential Kohlrausch relaxation, ∼ exp[-(*t*/*τ*)*^{β}*], with *β* = 0.6. In theories of relaxation in complex systems, *β* = *d*/*(d* + 2) where d is the dimensionality of the diffusion equation describing the relaxation process. Reference is made to J. C. Phillips, Journal of Non-Crystalline Solids 352, 4490 (2006). Our experimental value of *β* corresponds to *d* = 3 (see Figure 7 for more details on the fitting). Consistent with theory, the measured dependence of the relaxation time on temperature follows a simple exponential, *τ* = *τ*₀ *exp*(*-E*/*k_{B}T*), as seen in Figure 1F. Here the fitted attempt rate 1/*τ*₀ = 1.6 THz is within the typical antiferromagnetic dynamics scale. For the activation energy we obtained *E*/*k_{B}* = 27 × 300 K in our CuMnAs antiferromagnet whose Neel temperature is 480 K and reference is made to P. Wadley et al., Nature Communications 4, 2322 (2013) ibid*.*

In Figures 2A and 2B we show that the *R_{T}* signal flips sign when the pulsing is performed in the horizontal direction. The sign change *of R_{T} is* a direct consequence of the Wheatstone bridge geometry. However, Figure 2B also illustrates that the switching between opposite sign signals is reversible and reproducible. Besides the unipolar set/reset functionality, we can therefore also perform multipolar switching of the sign of the signal where the vertical pulse sets the vertical arms and resets the horizontal arms and *vice versa.* See Figure 5 for the simulation of the heat distribution in the device at the end of the writing pulse.

To directly highlight the large amplitude of the resistive changes in our device we plot in Figure 2D switching signals corresponding to the pulsing sequence of Figure 2A but measured in the longitudinal set-up which does not remove the off-set (see inset of Figure 2C). The corresponding switching signal Δ*R_{L}* is smaller than Δ*R_{T}* by the bridge geometry factor. The relative size of the resistive change inferred from the longitudinal measurement at 300 K is *ΔR_{L}*/*Rₘᵢₙ* = 20% (see Figure 2D). In Figure 2E, we then plot the measured dependence of the relative switching signal at 300 K over the full range of writing current amplitudes where we stayed safely below the sample breakdown. We see no switching signal at lower currents and an abrupt onset followed by a rapid increase with increasing writing current amplitude. This characteristic allows for a clear separation of writing and reading currents.

In Figure 2C, we study the temperature dependence of the switching signal by performing the following measurement: We applied the vertical writing pulse at base temperature of 250 K where the relaxation of the signal is significantly slowed down compared to the 300 K data in Figure 2B and 2D. We then cooled the sample to 50 K and measured *R_{L}* for 30 min. After that we increased the temperature by 50 K and again performed the 30 min readout measurement. The same procedure was repeated until we returned to 250 K. Next we applied the horizontal writing pulse and performed the same sequence of measurements as for the vertical pulse. The data show that the absolute amplitude of the switching signal is virtually temperature independent while the resistance of our metallic film strongly decreases with decreasing temperature. As a result, our relative switching signals approach 100% at low temperature.

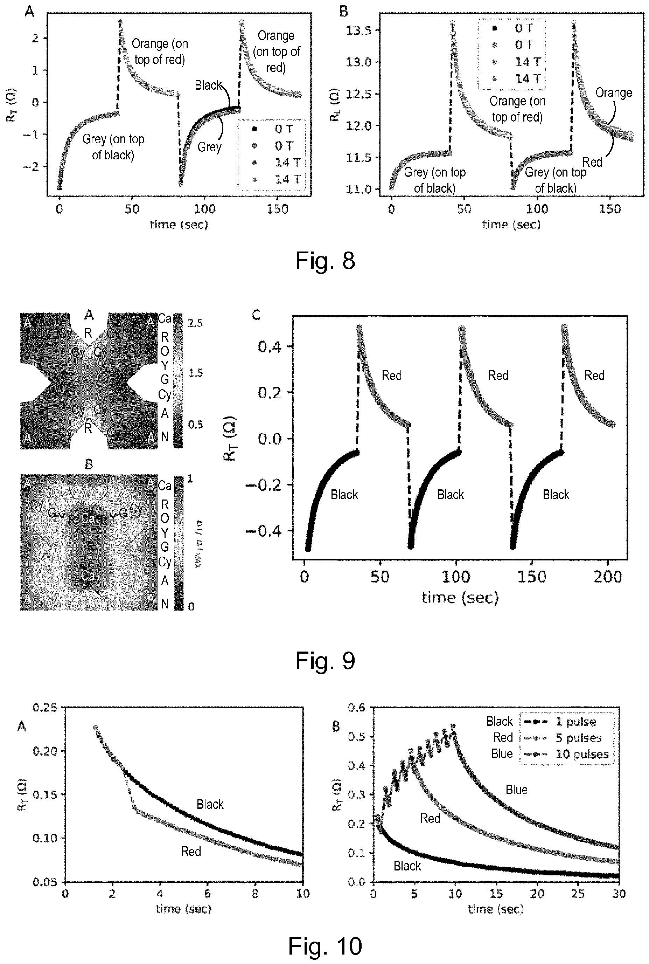

In Figure 8, we illustrate that switching in our antiferromagnetic devices is insensitive to magnetic fields which we tested up to 14 T. For completeness, we also show in Figure 9 large switching signals recorded in a four-terminal device without the lithographically removed central square region.

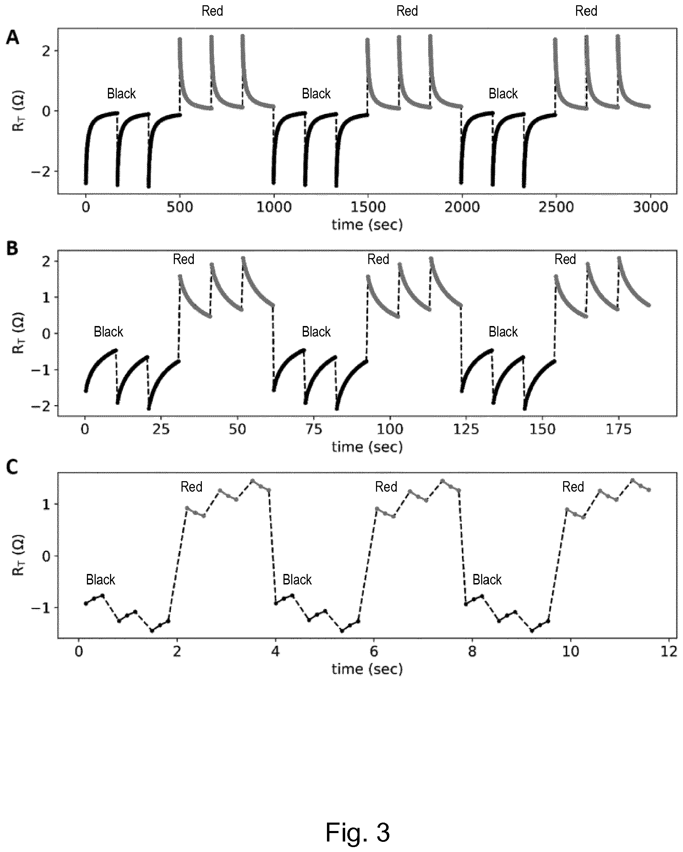

In Figure 1 we have demonstrated the unipolar set/reset functionality controlled by the current amplitude and in Figure 2 we have shown the reproducible switching of the sign of the signal by successive vertical and horizontal writing pulses of the same amplitude. Next we illustrate that the precise reproducibility of our switching patterns is observed also when sending multiple writing pulses of the same orientation and amplitude. Moreover, we can control the corresponding multi-level switching characteristics by changing the time-delay between successive pulses. In Figure 3A we show an example of *R_{T}* measured for three pulses applied in the same direction with a delay between pulses on the scale of the signal relaxation time at room temperature. Here each pulse brings the system from a (nearly) relaxed state into a similar high resistive state. The whole *R_{T}* pattern flips sign for the orthogonal pulse direction but otherwise is identical.

Data for pulse delays shorter than the relaxation time are plotted in Figures 3B and 3C. Here each successive pulse further increases the switching signal until the pulse direction is changed (or until we apply the reset pulse). The amplitudes and relaxations are precisely reproducible in all these measurements. The observed local-time pulse-counter functionality and the ability to reset our memory device can mimic a spiking neuron whose state remains unchanged for larger separations of successive input pulses and only approaches the firing threshold when the pulse-delay is short, after which it resets to the initial state.

### Switching by fs-laser pulses

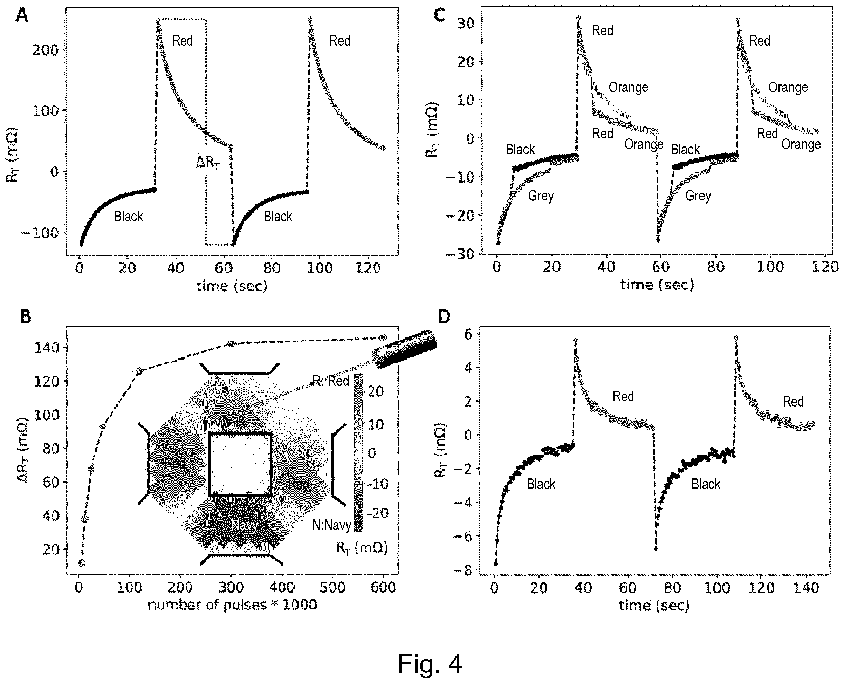

For consistency, we used 100 µs writing pulses in all electrical experiments presented hereinbefore. Since our devices have analogous switching characteristics over the full explored range of current pulse lengths down to 1 ns (see Figure 10), we now move directly to our results on the optical control. In the optical measurement shown in Figure 4A we used a 800 nm wavelength laser beam with a 1 µm spot size and an energy of 0.8 nJ per 100 fs pulse. To demonstrate comparably large switching signals achievable in electrical and optical experiments, we show in Figure 4A the *R_{T}* signal measured after completing a scan of the laser beam over one arm of the device. Here the laser pulse repetition rate was set to 80 kHz and the exposure of the arm was completed in 600 ms. After recording the resulting *R_{T}* signal and measuring its relaxation over 30 s, we performed analogous measurement in the orthogonal arm which gives the expected opposite sign *of R_{T}.* The whole procedure is repeated twice to demonstrate, besides the large signal, also the reproducibility of the optical writing. The asymmetry in the switching signal is due to experimental asymmetry in the spot alignment between the orthogonal arms.

In the inset of Figure 4B, we plot results of an experiment in which each micron-size pixel was exposed to a train of pulses with a 10 kHz repetition rate over 250 ms. Then we recorded the readout *R_{T}* signal and shifted the laser spot to the next pixel and repeated the same measurement procedure. As a result, we obtain a spatial switching map of the device with the resolution limited by the laser spot size.

As in the electrical switching experiments, the optically-generated signals are also multilevel. Given the high pulse repetition rates, we can explore this behavior in the optical measurements over orders of magnitude higher numbers of pulses, as illustrated in the main panel of Figure 4B. Here we performed the same type of experiment as in Figure 4A with the energy per pulse of 0.7 nJ, and we plot *ΔR_{T}.* Using a pulse-picker, the points in Figure 4B were obtained with the 600 ms long pulse train as in Figure 4A while the repetition rate was increased from 10 kHz to 1 MHz.

In Figure 4C, we show that we can optically set and reset the memory state as in the unipolar electrical experiment. In the measurement in Figure 4C we fixed the position of the laser spot in the horizontal arm and first applied the 1 µm-focus setting laser beam with 10 kHz repetition rate over 250 ms. Then we measured for 5 s or 20 s (black or grey curve in Figure 4C) the readout signal. Next we applied the resetting laser pulse in which we defocused the beam to a 1.8 µm diameter to reduce its maximum power. We repeated the same procedure also in the vertical arm. The result is consistent with the reset mechanism by the accelerated relaxation at elevated temperature induced by the second, defocused laser pulse.

Finally, in Figure 4D, we show the switching signal when the pulse-picker selects a single 100 fs 1 µm-focus pulse delivered to one spot on the horizontal arm. For the experiment we used a device with 2.5 µm wide arms and an energy of 1 nJ in the 100 fs pulse. We observe a switching signal of the same characteristics as in the previous electrical or optical experiments herein described. Also as we expected, the resistive readout signal flips sign when we shift the single 100 fs pulse to a spot on the vertical arm of the device.

### Discussion

Our observation of large resistive signals in a simple film, of unipolar switching, and insensitivity to magnetic fields is unparalleled in conventional ferromagnetic memories and is instead reminiscent of structural phase change memories. However, we have not identified by electron or atomic force microscopy measurements any signatures that would link the measured switching signals to structural changes in the CuMnAs film after multiple write/read cycles. Moreover, other characteristics of our devices clearly indicate that information is encoded in our case into the magnetic state rather than a structural phase. These include the writing pulse length covering the full range from 100 µs to 100 fs, precise reproducibility, low energy switching, and endurance; in the optical experiments we exposed a single spot to over a million of pulses and demonstrated switching by a single 100 fs long optical pulse delivering 300 pJ of energy into the 1 µm spot-size of the antiferromagnet (considering a 30% absorption ratio).

In our results we have also emphasized the analogue local-time characteristics of our antiferromagnetic memory. Here the most conventional counterpart device is an electron-charge capacitor. However, on its own, the capacitor would have the same charging and discharging times. Electron-charge memories, therefore, require additional circuitry to make the two times different. Our antiferromagnetic memory cells with a geometry as trivial as a single two-terminal resistor offer intrinsically, in a single conductive layer and without additional circuit elements, a combination of short write times and long relaxation times with a virtually unlimited range of ratios between the two time-scales. Here we also note that we have observed no increase of the relative switching signal when reducing the thickness of the CuMnAs film from 50 to 20 nm. This further verifies that our functionality stems from the antiferromagnetic metal film and not from, e.g., electron charge trapping at the interface between the metallic film and the insulating substrate into which we do not detect any leakage current.

We can envisage a broad range of applications based on our memory concept. For example, delivering microsecond writing current pulses with less than a volt applied across the active part of our memory cell is readily compatible with edge internet-of-things (IoT) technologies. This, combined with the analogue local-time characteristics, opens a research path towards applications in the IoT utilizing concepts of spiking neural network components. From the opposite end of the spectrum, the demonstrated sub-nJ switching energies of a micron-diameter area by a single 100 fs pulse brings our concept into the field of ultra-fast control of magnetism by modern laboratory laser systems. The numbers also imply that a pocket 1 W semiconductor laser diode can switch our memory with pulses as short as 1 ns. This combined with the electrical readout and the spatial resolution limited by the laser-focus opens new corners of optoelectronics research and development.

Our antiferromagnetic films are only tens of nm thick and the observed Kohlrausch relaxation exponent suggests that the diffusion process is three-dimensional. This implies that a microscopy resolution on the ∼10 nm or lower scale might be needed to image the full complexity of the textures of the written states. In the earlier XMLD-PEEM experiments in CuMnAs, the resolved feature sizes reached the limit of the ∼100 nm instrumental resolution for the studied metallic antiferromagnetic layers. Computer simulations might be helpful in elucidating the critical length-scale at which substantial changes in the resistance can already occur due to magnetic disorder. Simultaneously, short-range magnetic interactions at this critical length-scale should be no longer efficient in rapidly driving the system to equilibrium. Instead, due to the absence of long-range dipolar fields in antiferromagnets, the complex stretched-exponential diffusion process takes over.

### Examples of devices

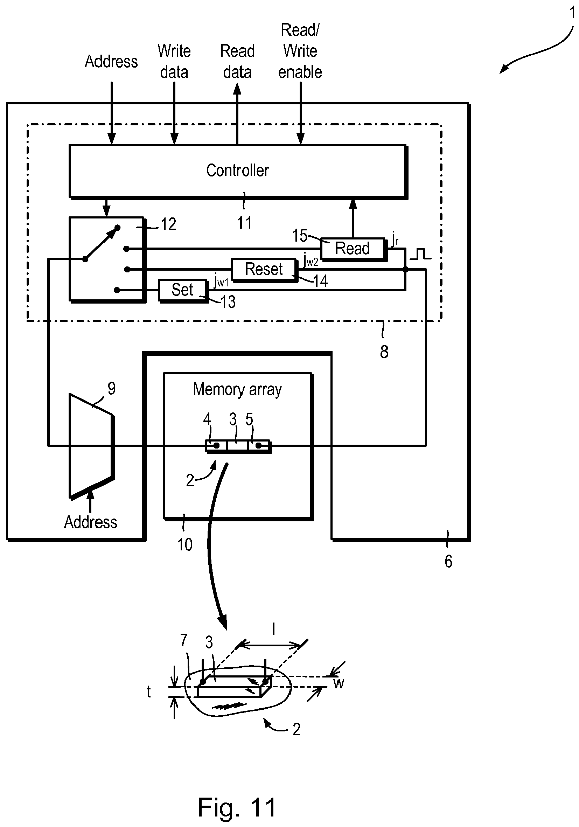

Referring to Figure 11, a first memory device 1 is shown.

The memory device 1 includes a memory element 2 comprising an antiferromagnet 3 having first and second contacts 4, 5 and a circuit 6 for driving a current between the first and second contacts 4, 5 through the antiferromagnet 3.

The antiferromagnet 3 may take the form of a pad or strip of antiferromagnetic material, such as CuMnAs, supported on a substrate 7 and having a thickness, t, a length, *l*, and a width, *w*. The thickness, *t,* may lie in a range between, for example, 5 nm and 50 nm. The thickness, *t,* may be smaller than 5 nm. Generally, making the strip or pad thin increases resistance. A higher resistance can be desirable for memory devices. The length, *l*, may lie in a range between, for example, 5 nm and 10 µm. The width, w, may lie in a range between, for example, 10 nm and 1 µm. Generally, making the ratio of length to width (*i.e., l*/*w)* of the device high increase resistance.

The circuit 6 includes a first part 8 for reading and writing data and may include a second part 9 for addressing an individual memory element 2, for example, in a memory array 10.

The circuit 6 includes a controller 11 and a switch 12 for switching between different modes, namely set mode 13, a reset mode 14 and read mode 15. Each mode 13, 14, 15 uses a different current density. In the set mode, the circuit 6 drives a first current pulse having a first current density *j*_{w1} through the antiferromagnet 3 in a first direction, wherein *jₜ* < *j*_{w1} where *jₜ* is a threshold current density for causing a change in resistance in the antiferromagnet 3, so as to set the memory element 2 in a first state having a first resistance R₁. In the reset mode 14, the circuit 6 drives a second current having a second current density *j*_{*w*2} through the antiferromagnet 3 in the first direction, wherein *jₜ < j*_{*w*2} *< j*_{*w*1} so as to reset the memory element 2 from the first state to a second state having a second resistance R₂, where (R₁ - R₂)/R₂ > 0.05. In the read mode 15, the circuit 6 drives a third current having a third current density *jᵣ* through the antiferromagnet 3, wherein *jᵣ < jₜ.*

As explained earlier, the threshold current, *jₜ,* can lie in a range 1.1×10⁷ Acm⁻² *<jₜ <* 1.2×10⁷ Acm⁻². However, the threshold current can be higher or lower (for example, depending on the antiferromagnetic material) and can be found by experiment.

The duration of a set/reset/read pulse can be 100 µs. However, a shorter pulse can be used and can be found by experiment. As explained hereinbefore, pulses as short as 100 fs can be used. The set, reset, and read pulse need not all have the same duration.

For writing (or "programming"), the set and reset pulses (having different current magnitudes) are used to set and reset the memory element 2 respectively. There is no need to read the memory element 2 to ascertain the state as part of the writing process. In other words, writing is deterministic.

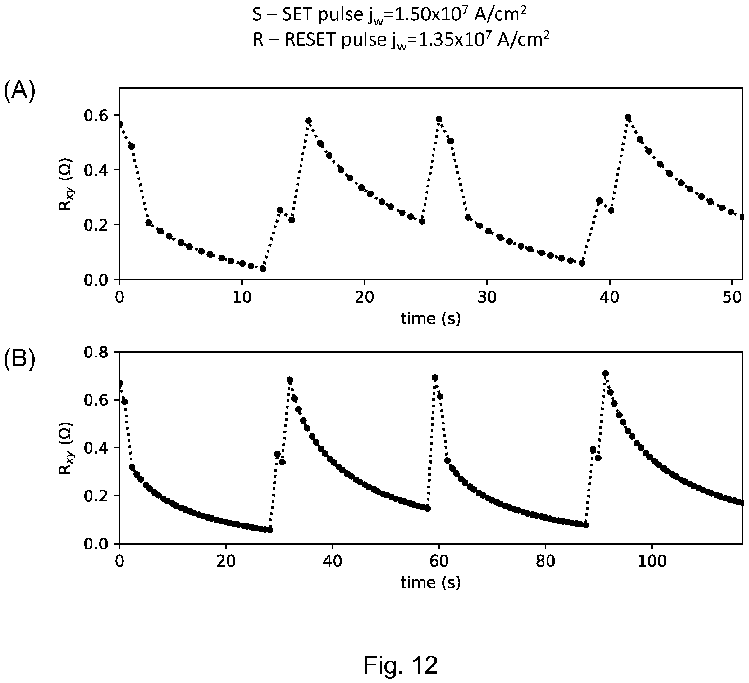

Referring to Figure 12A, a first set of resistance measurements of the memory element 2 are shown. A series of reset (R) and set (S) pulses are applied to the memory element 2 and the memory element 2 exhibits two states, namely a LOW state (or "reset") and a HIGH state (or "set").

Figure 12A shows that the memory element 2 is switched deterministically between the LOW and HIGH states, *i.e.,* applying a reset pulse when the memory element 2 is in a LOW state simply refreshes the state, while applying set pulse when the memory element 2 is in a LOW state causes the memory element to switch to a HIGH state.

Figure 12A also shows that the states gradually decay. Therefore, a refresh of a state can be applied to the memory element 2 after a predetermined period of time.

Referring to Figure 12B, a second set of resistance measurements of the memory element 2 are shown. The second set of measurements are similar to the first set in that a series of reset (R) and set (S) pulses are applied to the memory element 2 and the memory element 2 exhibits LOW and HIGH states. The second set of measurements are performed over a longer period.

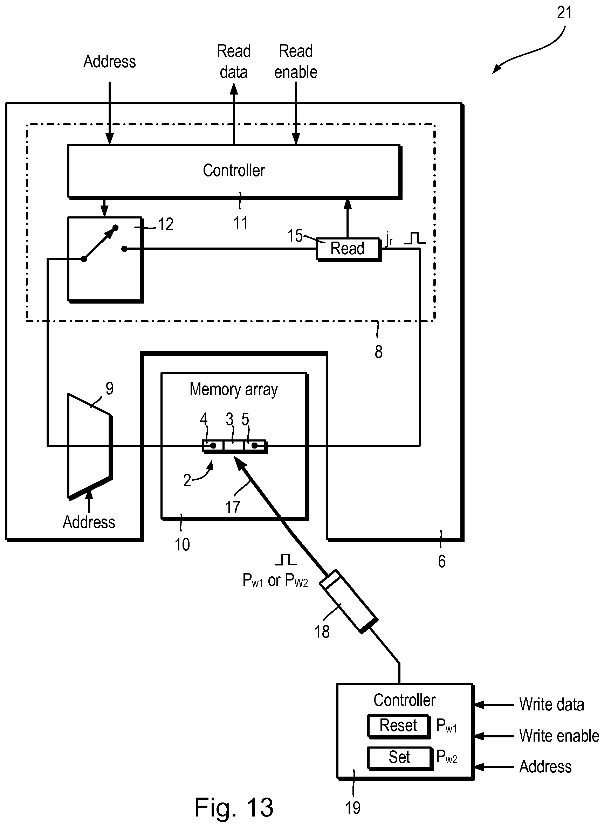

Referring to Figure 13, a second memory device 21 is shown.

The second memory device 2 is similar to the first memory device 11 except that rather than electrically setting and resetting the antiferromagnet 3, the second memory device 12 optically sets and resets the antiferromagnet 3.

The second memory device 2 uses a laser system 18 which is controlled by a controller 19. In a set mode 13, the controller 19 causes the laser system 18 to direct a first laser pulse having a first energy density *E*_{*w*1} and a first pulse duration at the antiferromagnet 3, wherein *Eₜ < E*_{*w*1} where *Eₜ* is a threshold energy density for causing a change in resistance in the antiferromagnet, so as to set the memory element 2 in a first state having a first resistance R1. In a reset mode, the controller 19 causes the laser system 18 to direct a second laser pulse having a second current density Ew2 and a second pulse duration at the antiferromagnet, wherein *Eₜ < E*_{*w*2} *< E*_{*w*1} so as to reset the memory element from the first state to a second state having a second resistance *R*₂, where (*R*₁ - *R*₂)/*R*₂ > 0.05. For sufficiently short pulses (*i.e.,* less than or equal to 10 µs), the threshold energy density, *Eₜ*, is about 1 kJcm⁻³ and can be found by experiment.

The memory element 2 is read electrically as hereinbefore described.

The memory element 2 can not only be programmed optically but can be read optically, for example, using reflectometry.

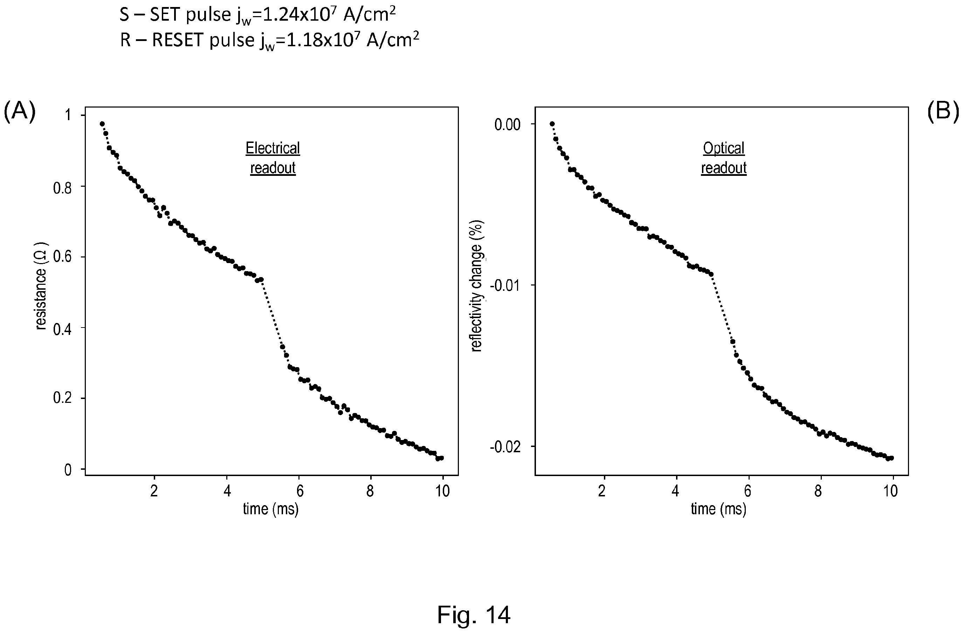

Referring to Figures 14A and 14B, respective electrical and optical readout measurements of a memory device are shown.

Figure 14A is a plot of resistance against time showing how the resistance of the memory element 2 gradually changes over a period of time.

Figure 14B is a plot of change in reflectance against time for the same device. The reflectance measurement is performed using a laser at a wavelength of 800 nm (which is the same wavelength used for writing) and a power of 0.3 mW.

Figures 14A and 14B show that the state of the memory element 2 can be read out electrically or optically. Optical read out may be used, for example, for when an electrically insulating antiferromagnet is used.

### References

1. T. Jungwirth, X. Marti, P. Wadley, J. Wunderlich, Nature Nanotechnology 11, 231 (2016).
2. C. Chappert, A. Fert, F. N. Van Dau, Nature Materials 6, 813 (2007).
3. P. Wadley, et al., Science 351, 587 (2016).
4. M. Meinert, D. Graulich, T. Matalla-Wagner, Physical Review Applied 9, 064040 (2018).
5. S. Y. Bodnar, et al., Nature Communications 9,348 (2018).
6. T. Moriyama, K. Oda, T. Ohkochi, M. Kimata, T. Ono, Scientific Reports 8,14167 (2018).
7. Z. Chen et al., Physical Review Letters 120, 207204 (2018).
8. L. Baldrati *et al.,* arXiv:1810.11326 [cond-mat.mtrl-sci] (2018).
9. J. Ẑelezný et al., Physical Review Letters 113, 157201 (2014).
10. A. Manchon et al., Reviews of Modern Physics in press (2018).
11. P. Wadley et al., Scientific Reports 5, 17079 (2015).
12. K. Olejník et al., Nature Communications 8, 15434 (2017).
13. M. J. Grzybowski et al., Physical Review Letters 118, 057701 (2017).
14. P. Wadley et al., Nature Nanotechnology 13, 362 (2018).
15. J. Godinho et al., Nature Communications 9, 4686 (2018).
16. F. Máca et al., Physical Review B 96, 094406 (2017).
17. J. C. Phillips, Journal of Non-Crystalline Solids 352, 4490 (2006).
18. Wulfram Gerstner, Werner M. Kistler, Spiking Neuron Models (Cambridge University Press, 2002).
19. A. V. Kimel, M. Li, Nature Reviews Materials 4,189 (2019).
20. P. Wadley et al., Nature Communications 4, 2322 (2013).
21. A. Kurenkov et al., Advanced Materials 31, 1900636 (2019).

### Modifications

It will be appreciated that various modifications may be made to the embodiments hereinbefore described. Such modifications may involve equivalent and other features which are already known in the design, manufacture and use of memory devices and component parts thereof and which may be used instead of or in addition to features already described herein. Features of one embodiment may be replaced or supplemented by features of another embodiment.

Other antiferromagnetic materials can be used. For example, the material can be another semiconductor. The antiferromagnetic material may be a metal, such as MnAu2. The antiferromagnetic material may be semi-metal. The antiferromagnetic material may even be a dielectric material (*i.e.,* electrically insulating).

Other measurable properties, preferably physical properties, of the antiferromagnetic material can used. The properties may be electrical properties and/or optical properties.

Although claims have been formulated in this application to particular combinations of features, it should be understood that the scope of the disclosure of the present invention also includes any novel features or any novel combination of features disclosed herein either explicitly or implicitly or any generalization thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A memory device comprising:
a memory element comprising an antiferromagnet having first and second contacts; and
a circuit for driving a current between the first and second contacts through the antiferromagnet, the circuit configured:
in a set mode, to drive a first current pulse having a first current density *j_{w1}* and a first pulse duration through the antiferromagnet in a first direction, wherein *jₜ < j_{w1}* where *jₜ* is a threshold current density for causing a change in resistance in the antiferromagnet, so as to set the memory element in a first state having a first resistance *R*₁;
in a reset mode, to drive a second current having a second current density *j*_{*w*2} and a second pulse duration through the antiferromagnet in the first direction, wherein *jₜ* < *j_{w2} < j_{w1}* so as to reset the memory element from the first state to a second state having a second resistance *R*₂, where (*R*₁ - *R*₂*)*/*R*₂ > 0.05; and
in a read mode, to drive a third current pulse having a third current density *jᵣ* through the antiferromagnet, wherein *jᵣ < jₜ.*

2. The memory device of claim 1, wherein 1.1×10⁷ Acm⁻² *< jₜ* < 1.2×10⁷ Acm⁻².

3. A memory device comprising:
a memory element comprising an antiferromagnet;
a laser system for directing laser pulse(s) at the antiferromagnet, the laser system configured:
in a set mode, to direct a first laser pulse having a first energy density *E_{w1}* and a first pulse duration at the antiferromagnet, wherein *Eₜ < E_{w1}* where *Eₜ* is a threshold energy density for causing a change in a measurable property of the antiferromagnet, so as to set the memory element in a first state having a first value of the measurable property *R*₁; and
in a reset mode, to direct a second laser pulse having a second energy density *E_{w2}* and a second pulse duration at the antiferromagnet, wherein *Eₜ < E_{w2} < E_{w1}* so as to reset the memory element from the first state to a second state having a second value of the measurable property *R*₂, where (*R*₁ - *R*₂)/*R*₂ > 0.05; and
a reading system for measuring a value of the measurable property, the system configured:
in a read mode, to measure a value of the measurable property without causing a change in the measurable property the antiferromagnet.

4. The memory device of claim 3, wherein the measurable property is resistance, the antiferromagnet has first and second contacts and the reading system includes a circuit for driving a current between the first and second contacts through the antiferromagnet.

5. The memory device of claim 3, wherein the measurable property is reflectivity and the reading system includes a laser orientatable at the antiferromagnet and a photodetector arranged to receive reflected light from the antiferromagnet.

6. The memory device of any one of claims 3 to 6, wherein the threshold energy density is greater than or equal to 0.1 kJcm⁻³ or greater than or equal to 1 kJcm⁻³.

7. The memory device of any one of claims 1 to 6, where (*R*₁ - *R*₂)/*R*₂ > 0.2.

8. The memory device of any one of claims 1 to 4, wherein (*R*₁ - *R*₂)/*R*₂ > 0.9.

9. The memory device of any one of claims 1 to 8, wherein the first pulse duration is less than or equal to 100 µs.

10. The memory device of any one of claims 1 to 9, wherein the first pulse duration is between 100 fs and 100 µs.

11. The memory device of any one of claims 1 to 10, wherein the antiferromagnet comprises a body of antiferromagnetic material.

12. The memory device of claim 11, wherein the body of antiferromagnetic material has a volume less than 0.1 µm³.

13. The memory device of any one of claims 1 to 12, comprising:
an array of memory elements, each memory element comprising a respective antiferromagnet; and
a controller for controlling setting, resetting and reading of the memory elements in the array of memory elements.

14. A method of operating a memory device which comprises a memory element comprising an antiferromagnet, the method comprising:
in a set mode, providing a first pulse of a first energy density *E_{w1}* and a first pulse duration at the antiferromagnet, wherein *Eₜ < E_{w1}* where *Eₜ* is a threshold energy density for causing a change in a measurable property of the antiferromagnet, so as to set the memory element in a first state having a first value of the measurable property *R*₁;
in a reset mode, providing a first pulse of a second energy density *E_{w2}* and a second pulse duration at the antiferromagnet, wherein *Eₜ < E_{w2} < E_{w1}* so as to reset the memory element from the first state to a second state having a second value of the measurable property *R*₂, where (*R*₁ - *R*₂)/*R*₂ > 0.05; and
in a read mode, measuring a value of the measurable property without causing a change in the measurable property the antiferromagnet.

15. The method of claim 14, wherein the measurable property is resistance.
